# EUROPÄISCHE PATENTSCHRIFT

(11) **EP 2 524 431 B1**
(45) Veröffentlichungstag und Bekanntmachung des Hinweises auf die Patenterteilung: **19.11.2014**
(21) Anmeldenummer: 11700081.0
(22) Anmeldetag: 10.01.2011
(51) Int. Cl.: H03K 17/16, H02M 7/00

(54) **SCHALTUNGSANORDNUNG VON ELEKTRONISCHEN LEISTUNGSSCHALTERN EINER STROMERZEUGUNGSVORRICHTUNG**
CIRCUIT ARRANGEMENT OF ELECTRONIC CIRCUIT BREAKERS OF A POWER GENERATION DEVICE
CIRCUIT DE DISJONCTEURS ÉLECTRONIQUES D'UN GÉNÉRATEUR DE COURANT

(30) Priorität: 14.01.2010 DE 102010000082
(43) Veröffentlichungstag der Anmeldung: 21.11.2012
(73) Patentinhaber: Woodward Kempen GmbH, 47906 Kempen (DE)
(72) Erfinder: HÜBBERS, Heiner, 47809 Krefeld (DE); HARTMANN, Eric, 47906 Kempen (DE)
(74) Vertreter: Cohausz & Florack
(86) Internationale Anmeldenummer: PCT/EP2011/050228
(87) Internationale Veröffentlichungsnummer: WO 2011/086048

(56) Entgegenhaltungen:
- US-A- 5 579 217
- US-A1- 2004 208 030
- US-A1- 2006 007 721

## Beschreibung

Die Erfindung betrifft eine Schaltungsanordnung mit mindestens einem elektronischen Leistungsschalter, mindestens einem Kondensator und einem plattenförmigen Gleichstromlaminat, wobei das Gleichstromlaminat mindestens zwei gegeneinander isolierte Metallplatten zur Stromführung und eine Mehrzahl in einem ersten Rastermaß angeordneter Anschlusselemente zum elektrischen Verbinden der Metallplatten mit dem mindestens einen Kondensator aufweist, der mindestens eine Kondensator über die im ersten Rastermaß angeordneten Anschlusselemente mit dem Gleichstromlaminat elektrisch verbunden ist und der mindestens eine Kondensator auf einer Seite des Gleichstromlaminats angeordnet ist, das Gleichstromlaminat zusätzlich eine Mehrzahl in einem zweiten Rastermaß angeordneter Anschlusselemente zum Verbinden des Gleichstromlaminats mit mindestens einem elektronischen Leistungsschalter der Schaltungsanordnung aufweist, das mindestens ein elektronischer Leistungsschalter über die im zweiten Rastermaß angeordneten Anschlusselemente mit dem Gleichstromlaminat elektrisch verbunden ist und auf der gegenüberliegenden Seite des Gleichstromlaminats angeordnet ist, wobei elektronische Leistungsschalter für drei Phasen vorgesehen sind und die auf der einen Seite des Gleichstromlaminats angeordneten elektronischen Leistungsschalter zumindest teilweise einen gemeinsamen Kühlkörper aufweisen.

Schaltungsanordnungen mit elektronischen Leistungsschaltern, also elektronischen Schaltern wie beispielsweise Dioden, Transitoren, Insulated-Gate-Bipolar-Transistoren(IGBT), Integrated-Gate-Commutated-Thyristoren(IGCT)oder Modulen mit diesen Bauteilen und Kondensatoren werden häufig in Vorrichtungen zur Erzeugung von Strom, beispielsweise in einem Gleich- oder Wechselrichter einer Windenergieanlage, einer Photovoltaikanlage oder in sonstigen Stromerzeugern mit Invertertechnik eingesetzt. Der mindestens eine Kondensator, üblicherweise eine Mehrzahl von Kondensatoren, dient zur Bereitstellung eines Gleichspannungszwischenkreises. Durch das Ein- und Ausschalten der elektronischen Schalter wird Wechselin Gleichstrom bzw. andersherum umgewandelt. Beim Ein- und Ausschalten der elektronischen Leistungsschalter sind hohe Schaltgeschwindigkeiten erforderlich, um Leistungsverluste insgesamt gering zu halten. Dadurch entstehen große Stromänderungen, welche Spannungen induzieren, die möglichst gering gehalten werden sollen. Dazu ist es notwendig, die Induktivität der Verbindungen zwischen den Schaltern und dem Gleichspannungszwischenkreis so klein wie möglich zu halten. Aus diesem Grunde werden die elektronischen Leistungsschalter mit den Kondensatoren über Gleichstromlaminate verbunden, welche möglichst dünn, flach und breit gehalten werden, so dass große Überlappungsbereiche entstehen, in welchen in entgegengesetzte Richtung fließende Ströme eng benachbart sind und die entstehenden Magnetfelder sich gegenseitig überlappen. Hierdurch wird erreicht, dass sich die erzeugten Magnetfelder gegenseitig eliminieren, so dass die Induktanz der stromführenden Bauteile sehr gering ist.

Eine Schaltungsanordnung ist aus der US-Patentschrift US 5,579,217 bekannt, welche ein plattenförmiges Gleichstromlaminat bestehend aus mehreren leitenden Schichten aufweist, die gegeneinander isoliert sind, wobei die leitenden Schichten Anschlüsse aufweisen, die mit mehreren elektronischen Leistungsschaltern für drei Phasen verbunden sind, die auf der gegenüberliegenden Seite des Gleichstromlaminats angeordnet sind und einen gemeinsamen Kühlkörper aufweisen.

Aus der US 2006/0007721 A1 ist darüber hinaus eine Schaltungsanordnung für Leistungsmodule bekannt, bestehend aus mindestens zwei Leistungsschalterpaaren auf der einen Seite einer Grundplatine und den Kondensatoren auf der anderen Seite der Grundplatine, wobei die Grundplatine dabei aus einer Laminierung mehrere leitender und isolierender Schichten beseht und die Leistungsschalterpaare zur Kühlung auf einer Platte 82 aus Kupfer oder Aluminium befestigt sind.

Nachteilig an beiden bekannten Schaltungsanordnungen ist jedoch, dass wesentliche Teile der Schaltungsanordnung, insbesondere das Gleichstromlaminat, neu konstruiert werden müssen, sobald elektronische Leistungsschalter von unterschiedlichen Herstellern und/oder Bauarten mit unterschiedlichen Anschlussgeometrien verwendet werden.

Aus der deutschen Patentschrift DE 197 32 402 B4 ist eine weitere Schaltungsanordnung bekannt, welche ein Gleichstromlaminat bestehend aus zwei gegeneinander isolierte und benachbart angeordneten Metallplatten aufweist, welches zur Verbindung von elektronischen Leistungsschaltern mit einer Kondensatorbank dient. Die Kondensatoren sind über eine Mehrzahl in einem ersten Rastermaß angeordneter Anschlusselemente mit dem Gleichstromlaminat elektrisch verbunden und auf einer Seite des Gleichstromlaminats angeordnet. Die elektronischen Leistungsschalter sind in der aus dem Stand der Technik bekannten Schaltungsanordnung abgewinkelt angeordnet, so dass die elektronischen Leistungsschalter neben dem Gleichstromlaminat angeordnet sind. Die elektronischen Leistungsschalter sind ferner mit Anschlussfortsätzen des Gleichstromlaminats elektrisch verbunden. Diese Anordnung hat den Nachteil, dass einerseits die Gleichstromlaminate individuell an die Ausführungsformen der elektronischen Leistungsschalter angepasst werden müssen, so dass beim Einsatz von elektronischen Leistungsschaltern unterschiedlicher Hersteller und Bauart unterschiedliche Gleichstromlaminate konstruiert und hergestellt werden müssen. Andererseits ist die Raumnutzung dieser Schaltungsanordnung nicht optimal. Ein Ziel bei der Konstruktion entsprechender Schaltungsanordnungen ist aber, einen möglichst kompakten Aufbau zu erreichen, um den Platzbedarf zu minimieren. Schließlich ist die bekannte Schaltungsanordnung nicht ohne weiteres an höhere Leistungen skalierbar.

Hiervon ausgehend liegt der vorliegenden Erfindung die Aufgabe zugrunde, eine Schaltungsanordnung zur Verfügung zu stellen, welche einen deutlich verringerten Platzbedarf und gleichzeitig eine verbesserte Skalierbarkeit aufweist und welche eine einfache Verwendung von elektronischen Leistungsschaltern unterschiedlicher Hersteller und Bauarten mit unterschiedlichen Anschlussgeometrien ermöglicht. Darüber hinaus soll eine Stromerzeugungsvorrichtung mit entsprechend geringem Platzbedarf vorgeschlagen werden.

Erfindungsgemäß wird die oben hergeleitete Aufgabe für eine Schaltungsanordnung dadurch gelöst, dass mindestens ein Adapterlaminat zum Anschluss der elektronischen Leistungsschalter vorgesehen ist, wobei das Adapterlaminat auf einer Anschlussseite an den elektronischen Leistungsschalter angepasste Anschlusselemente und auf der anderen Anschlussseite an das zweite Rastermaß angepasste Anschlusselemente aufweist, die Querschnittsform des Adapterlaminats mindestens einen rechten Winkel aufweist, die Adapterlaminate derart angeordnet sind, dass die Kühlflächen der zumindest teilweise einen gemeinsamen Kühlkörper aufweisenden Leistungsschalter senkrecht zur Ebene des Gleichstromlaminats angeordnet sind und das Adapterlaminat genau zwei stromführende Schichten aufweist.

Das Gleichstromlaminat befindet sich erfindungsgemäß zwischen den elektronischen Leistungsschaltern und den Kondensatoren, so dass der Platz auf beiden Seiten des plattenförmigen Gleichstromlaminats besonders effektiv ausgenutzt wird. Darüber hinaus ermöglichen die im zweiten Rastermaß angeordneten Anschlusselemente des Gleichstromlaminats den variablen Anschluss von einem aber auch von mehreren elektronischen Leistungsschaltern an das Gleichstromlaminat, so dass eine einfache Skalierbarkeit der Schaltungsanordnung gegeben ist. Alle Anschlusselemente werden vorzugsweise durch Kontaktlöcher in der jeweiligen Metallplatte des elektrischen Anschlusspols des Gleichstromlaminats gebildet, so dass die einzelnen Kondensatoren und elektronischen Leistungsschalter elektrisch leitend mit dem Gleichstromlaminat verbunden werden können. Das erste Rastermaß und das zweite Rastermaß können entweder identisch oder voneinander verschieden ausgebildet sein.

Gemäß einer ersten Ausführungsform der erfindungsgemäßen Schaltungsanordnung ist eine Mehrzahl parallel geschalteter Kondensatoren, vorzugsweise eine Kondensatorbank vorgesehen, wobei die einzelnen Kondensatoren über die im ersten Rastermaß angeordneten Anschlusselemente mit dem Gleichstromlaminat elektrisch leitend verbunden sind. Das erste Rastermaß des Gleichstromlaminats ermöglicht eine besonders kompakte Anordnung der Kondensatoren, da das Rastermaß beispielsweise auf die Größe und den Raumbedarf der Kondensatoren abgestimmt werden kann.

Eine weitere vorteilhafte Ausführungsform der erfindungsgemäßen Schaltungsanordnung wird dadurch erreicht, dass die im zweiten Rastermaß angeordneten Anschlusselemente des Gleichstromlaminats derart ausgebildet sind, dass eine Mehrzahl an elektronischen Leistungsschaltern in achsensymmetrischer Anordnung mit dem Gleichstromlaminat elektrisch leitend verbunden werden können. Für die im zweiten Rastermaß angeordneten Anschlusselemente bedeutet dies, dass die elektrischen Anschlusspole beispielweise die Kontaktierung eines um 180 Grad gedrehten elektronischen Leistungsschalters ermöglicht. Die achsensymmetrische Anordnung von elektronischen Leistungsschaltern ermöglicht einen symmetrischen Aufbau der Schaltungsanordnung und insofern eine weitere Reduzierung des Raumbedarfs.

Die Wechselstromanschlüsse der Leistungsschalter können bei einer weiteren Ausführungsform der Schaltungsanordnung über Stromschienen, beispielsweise über Kupferschienen oder Kabel realisiert werden. Die Stromschienen können hierzu ein- oder beidseitig der Leistungsschalter aber auch entlang der Symmetrieachse der Leistungsschalteranordnung verlaufen. Dies hängt von der jeweiligen Anschlussgeometrie der Wechselstromanschlüsse des Leistungsschalters sowie der Platzverhältnisse im eingebauten Zustand der Schaltungsanordnung ab.

Gemäß einer weitergebildeten Ausführungsform der erfindungsgemäßen Schaltungsanordnung ermöglicht das zweite Rastermaß des Gleichstromlaminats eine horizontale oder eine vertikale Anordnung bzw. Aneinanderreihung von elektronischen Leistungsschaltern. Es können auch beide Anordnungsvarianten der elektronischen Leistungsschalter, also vertikal oder horizontal, durch ein einziges Gleichstromlaminat ermöglicht werden. Hierdurch wird ein Maximum an Flexibilität erreicht, da abhängig vom Platzangebot die elektronischen Leistungsschalter auf dem Gleichstromlaminat in vertikaler oder in horizontaler Richtung angeordnet werden können, ohne dass das Gleichstromlaminat neu konstruiert werden muss.

Die einfache Verwendung von elektronischen Leistungsschaltern unterschiedlicher Hersteller und Bauarten mit unterschiedlichen Anschlussgeometrien, ohne dass wesentliche Teile der Schaltungsanordnung, insbesondere das Gleichstromlaminat, neu konstruiert werden müssen, wird erfindungsgemäß dadurch erreicht, dass ein Adapterlaminat zum Anschluss der elektronischen Leistungsschalter vorgesehen ist, wobei das Adapterlaminat auf einer Anschlussseite an den elektronischen Leistungsschalter angepasste Anschlusselemente und auf der anderen Anschlussseite an das zweite Rastermaß angepasste Anschlusselemente aufweist. Durch die Verwendung von Adapterlaminaten können elektronische Leistungsschalter unterschiedlicher Hersteller und Bauart besonders einfach mit dem gleichen Gleichstromlaminat verwendet werden. Auch die Adapterlaminate sind derart konstruiert, dass die beiden stromführenden Schichten möglichst dünn, flach und breit gehalten werden, so dass sich große Überlappungsbereiche ergeben. Üblicherweise werden die elektronischen Leistungsschalter, beispielsweise über die Adapterlaminate mit dem Gleichstromlaminat durch Schraubverbindungen elektrisch leitend verbunden.

Eine weitere Ausgestaltung der erfindungsgemäßen Schaltungsanordnung verringert den Montageaufwand dadurch, dass die im zweiten Rastermaß angeordneten Anschlusselemente des Gleichstromlaminats Hülsen mit einem Innengewinde aufweisen. Zur Montage muss lediglich von der Seite der elektronischen Leistungsschalter her eine Schraube mit der Hülse des Gleichstromlaminats verschraubt werden. Die Hülsen können stoff-, form- oder kraftschlüssig mit dem Gleichstromlaminat verbunden sein. Stoffschlüssige Verbindungen können durch Löten, Kleben und Schweißen zur Verfügung gestellt werden. Eine Kombination aus Kraft- und Formschluss kann auf einfache Weise durch Einpressen der Hülsen in das Gleichstromlaminat bereitgestellt werden.

Die zwei Metallplatten des Gleichstromlaminats oder des Adapterlaminats liegen naturgemäß in zwei verschiedenen Ebenen. Deshalb werden bei der Kontaktierung häufig Kontakthülsen verwendet, welche die unterschiedlich tief liegenden Metallplatten gleichen Potentials miteinander kontaktieren. Gemäß einer weiteren Ausgestaltung der erfindungsgemäßen Schaltungsanordnung sind die Kontaktflächen der im zweiten Rastermaß angeordneten Anschlusselemente des Gleichstromlaminats und/oder die an das zweite Rastermaß angepassten Anschlusselemente des Adapterlaminats in einer Ebene angeordnet, so dass auf die Verwendung von Kontakthülsen zur Kontaktierung der Kontaktflächen der Metallplatten von Adapterlaminat und Gleichstromlaminat verzichtet werden kann.

Ein besonders einfaches Adapterlaminat ermöglicht die Anordnung der elektronischen Leistungsschalter auf einer Seite des Gleichstromlaminats dadurch, dass die Querschnittsform des Adapterlaminats mindestens einen rechten Winkel aufweist. Die elektronischen Leistungsschalter können in diesem Fall so angeordnet werden, dass die Kühlflächen senkrecht zur Ebene des Gleichstromlaminats ausgerichtet sind und eine vom Gleichstromlaminat und den auf der gegenüberliegenden Seite des Gleichstromlaminats angeordneten Kondensatoren unabhängige Wärmeabführung ermöglicht wird.

Eine weitere Kostenreduzierung und darüber hinaus eine deutliche Vereinfachung des Aufbaus der Schaltungsanordnung wird erfindungsgemäß dadurch erreicht, dass auf der einen Seite des Gleichstromlaminats angeordnete elektronische Leistungsschalter zumindest teilweise einen gemeinsamen Kühlkörper aufweisen. Hierdurch werden die Kosten für zusätzliche Kühlkörper eingespart.

Vorteilhaft ist die Nutzung eines gemeinsamen Kühlkörpers insbesondere dann, wenn der Kühlkörper durch ein flüssiges Kühlmedium gekühlt wird und optional modular aufgebaut ist. Bei der gemeinsamen Nutzung eines durch ein flüssiges Kühlmedium gekühlten Kühlkörpers werden vor allem zusätzliche Anschlüsse und damit potenzielle Leckagestellen mit der erfindungsgemäßen Schaltungsanordnung vermieden und insofern nicht nur eine deutlich Verringerung des Platzbedarfes erreicht, sondern auch die Betriebssicherheit in erheblichem Maße erhöht. Optional können die Kühlkörper auch modular aufgebaut sein. Modular im Sinne der vorliegenden Erfindung bedeutet, dass die Kühlkörper beispielsweise einzelnen elektronischen Leistungsschaltern aber auch Leistungsschaltergruppen zugeordnet werden können und bei Kombination verschiedener elektronischer Leistungsschaltergruppen ebenfalls auf einfache Weise mit weiteren Kühlkörpern verbunden werden können, um eine für die Schaltungsanordnung ausreichende Kühlung bereitzustellen.

Hierdurch werden weitere Kosten in der Entwicklung der Kühlkörper und der Konstruktion derselben eingespart.

Gemäß einer bevorzugten Ausführungsform der Schaltungsanordnung weisen die Kühlkörper jeweils separate Kühlmittelanschlüsse, welche beispielsweise über Adapter bereitgestellt werden, auf. Hierdurch kann eine Baueinheit bestehend aus Kühlkörper, Leistungsschalter und Adapterlaminat gebildet werden, welche aufgrund des geringeren Gewichts die Montage und den Austausch einzelner Leistungsschalter der Schaltungsanordnung erleichtert.

Die einzelnen Baueinheiten bestehend aus Leistungsschaltern, Kühlkörper und Adapterlaminat können nicht nur, wie bereits ausgeführt, achsensymmetrisch bzw. spiegelsymmetrisch aufgebaut sein. Die einzelnen Baueinheiten ermöglichen insbesondere auch eine einfache, parallele Anordnung beispielsweise in mehreren Reihen auf dem Adapterlaminat. Zwar wird hierdurch üblicherweise ein größeres Gleichstromlaminat benötigt, welches beispielsweise aus einem großen oder mehreren kleinen Gleichstromlaminaten besteht. Die Anordnung der gebildeten Baueinheiten dieser Ausführungsform der Schaltungsanordnung erleichtert aber insbesondere den Austausch der Baueinheiten und ermöglicht eine verbesserte Skalierbarkeit der Schaltungsanordnung. Die Baueinheiten können hierzu beispielsweise senkrecht oder horizontal hintereinander auf dem Gleichstromlaminat angeordnet werden.

Applikationsspezifisch kann es vorteilhaft sein, anstatt einer Flüssigkeitskühlung eine Luftkühlung einzusetzen. Hierbei wird der gemeinsame Kühlkörper forciert von Luft durchströmt. Die optionale Modularität der Kühlkörper ist auch in diesem Fall vorteilhaft und führt zu einer besseren Skalierbarkeit.

Gemäß einer weiteren Ausführungsform der erfindungsgemäßen Schaltungsanordnung ist eine Mehrzahl an Gleichstromlaminaten vorgesehen, welche über im Gleichstromlaminat jeweils vorgesehene Anschlussmittel miteinander elektrisch leitend verbunden sind. Hierdurch wird erreicht, dass die Gleichstromlaminate entsprechend der gewünschten Anzahl an elektronischen Leistungsschaltern beliebig erweiterbar sind. Die Anschlussmittel können eine Erweiterung des Gleichstromlaminats sowohl in vertikaler als auch in horizontaler Richtung ermöglichen und sind hierzu an den entsprechenden Stellen des Gleichstromlaminats angeordnet.

Berücksichtigt gemäß einer weiteren Ausgestaltung der erfindungsgemäßen Schaltungsanordnung das erste und/oder das zweite Rastermaß der Anschlusselemente des Gleichstromlaminats unterschiedliche Kondensator- und/oder Leistungsschalteranschlussgeometrien beispielsweise dadurch, dass die Anschlusselemente so gewählt werden können, dass unterschiedliche Anschlussabstände im jeweiligen ersten oder zweiten Rastermaß zur Verfügung stehen, können ohne Verwendung von Adapterlaminaten Anschlussgeometrien unterschiedlicher Hersteller berücksichtigt werden und ohne konstruktiven Aufwand verwendet werden.

Vorzugsweise ist als elektronischer Leistungsschalter mindestens ein Transistor, vorzugsweise mindestens ein Insulated-Gate-Bipolar-Transistor-(IGBT)-Modul, Integrated-Gate-Commutated-Thyristor(IGCT), Dioden und/oder mindestens ein Chopper-Modul (22) vorgesehen. Diese elektronischen Leistungsschalter werden üblicherweise in Vorrichtungen zur Stromerzeugung, beispielsweise Umrichtern mit kapazitiven Zwischenkreisen verwendet. Unter einem Chopper-Modul wird eine Kombination aus mindestens einem elektronischen Leistungsschalter, beispielsweise einem Transistor und mindestens einem Widerstand bezeichnet. Das Chopper-Modul dient dazu, den Zwischenkreis kurzzeitig kurz zu schließen und so andere elektronische Leistungsschalter beispielsweise die IGBT-Module aber auch die Kondensatoren vor Überspannungen zu schützen.

Das Chopper-Modul kann gemäß einer weiteren Ausführungsform entweder direkt mit dem Gleichstromlaminat elektrisch verbunden sein oder über ein spezifisches Adapterlaminat an das Gleichstromlaminat angeschlossen sein. Wird das Chopper-Modul direkt mit dem Gleichstromlaminat verbunden, werden einerseits die Kosten für ein Adapterlaminat eingespart. Das Adapterlaminat kann aber dazu verwendet werden, um das Chopper-Modul anwendungsspezifisch an einer geeigneten Stelle der Schaltungsanordnung anzuordnen, ohne das Gleichstromlaminat verändern zu müssen.

Erfindungsgemäß sind elektronische Leistungsschalter, vorzugsweise IGBT-Module, für drei Phasen vorgesehen. Beispielweise kann ein Wechselrichter eingangs- und ausgangsseitig mit jeweils drei elektronischen Leistungsschaltern aufgebaut sein. Im Bereich der Haustechnik bzw. zur Bereitstellung eines einphasigen Wechselstroms sind aber auch Schaltungsanordnungen mit zwei ausgangsseitigen elektronischen Leistungsschaltern denkbar.

Die oben hergeleitete Aufgabe wird darüber hinaus durch eine Stromerzeugungsvorrichtung mit einem Wechsel- oder Gleichrichter, welche eine erfindungsgemäße Schaltungsanordnung umfasst, gelöst. Wie bereits ausgeführt, weisen entsprechende Wechsel- oder Gleichrichter einen besonders geringen Platzbedarf auf und lassen sich mit sehr geringen Kosten an unterschiedliche Leistungserfordernisse anpassen.

Dies gilt insbesondere für eine Stromerzeugungsvorrichtung einer Windenergieanlage mit einem Generator, welche einen Gleich- oder Wechselrichter aufweist, in welchem eine erfindungsgemäße Schaltungsanordnung vorgesehen ist. Als Generatoren werden in Windenergieanlagen beispielsweise doppelt gespeiste Asynchronmaschinen aber auch Synchronmaschinen verwendet. Windenergieanlagen werden in unterschiedlichsten Leistungseinheiten konstruiert, so dass regelmäßig die Umrichter an die entsprechende Leistung der Windenergieanlage angepasst werden müssen. Dies gelingt mit der erfindungsgemäßen Schaltungsanordnung besonders kostengünstig. Ferner ist der Raumbedarf in einer Windenergieanlage meistens beschränkt, so dass der kompakte Aufbau der Schaltungsanordnung vorteilhaft ist. Insbesondere beim Einsatz von Synchronmaschinen mit Vollumrichtertechnik werden hohe Leistungen über die erfindungsgemäße Schaltungsanordnung geführt, so dass ein kompakter und skalierbarer Aufbau der Schaltungsanordnung besonders vorteilhaft ist.

Im Weiteren wird die Erfindung anhand der Beschreibung von Ausführungsbeispielen in Verbindung mit der Zeichnung näher erläutert. In der Zeichnung zeigt
- Fig. 1: in einer perspektivischen Darstellung ein erstes Ausführungsbeispiel der erfindungsgemäßen Schaltungsanordnung mit einer Kondensatorbank und einer Mehrzahl an elektronischen Leistungsschaltern,
- Fig. 2: in einer perspektivischen Darstellung das Gleichstromlaminat aus dem ersten Ausführungsbeispiel,
- Fig. 3: in einer perspektivischen Darstellung das Gleichstromlaminat zusammen mit den Adapterlaminaten aus dem ersten Ausführungsbeispiel,
- Fig. 4: in einer Draufsicht das Gleichstromlaminat aus dem ersten Ausführungsbeispiel,
- Fig. 5: eine Schnittansicht des Gleichstromlaminats im Bereich der Adapterlaminate,
- Fig. 6: in einer perspektivischen Darstellung ein zweites Ausführungsbeispiel der erfindungsgemäßen Schaltungsanordnung mit IGBT-Modulen und einem Chopper-Modul,
- Fig. 7: eine Baueinheit bestehend aus Leistungsschaltern, Kühlkörper und Adapterlaminaten gemäß einem dritten Ausführungsbeispiel,
- Fig. 8: ein viertes Ausführungsbeispiel der Schaltungsanordnung mit mehreren Baueinheiten gemäß Fig. 7,
- Fig. 9: ein weiteres Ausführungsbeispiel mit einem über ein zusätzliches Adapterlaminat angebundenes Chopper-Modul und
- Fig. 10: eine schematische Darstellung einer Windenergieanlage mit einer erfindungsgemäßen Schaltungsanordnung.

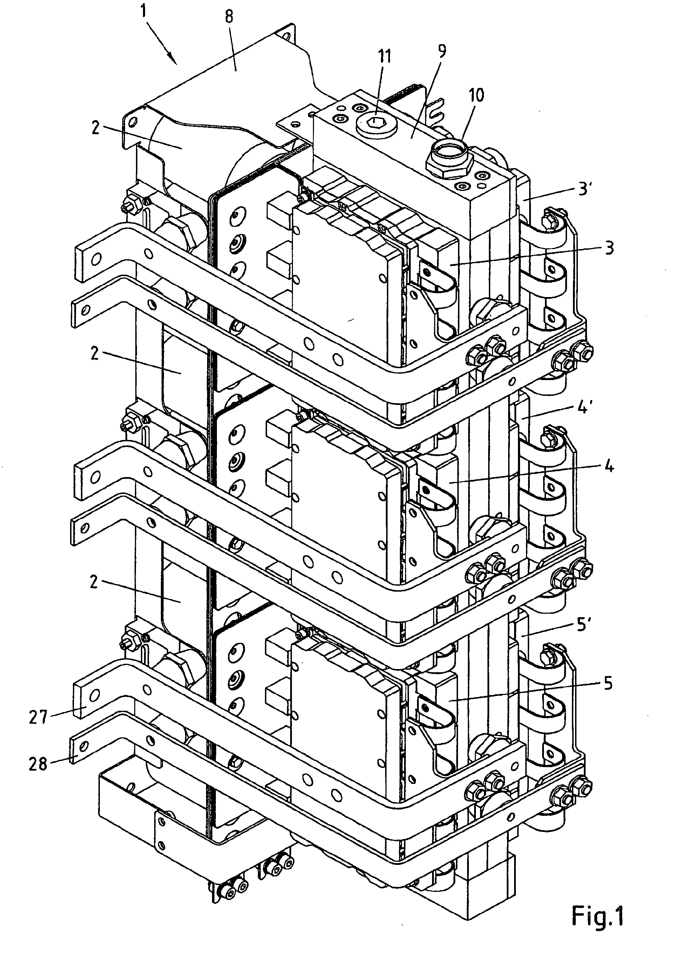

Figur 1 zeigt in einer perspektivischen Darstellung ein Ausführungsbeispiel der erfindungsgemäßen Schaltungsanordnung 1, mit einer Mehrzahl an Kondensatoren 2, insgesamt sechs elektronischen Leistungsschaltern in Form von IGBT-Modulen 3, 3', 4, 4', 5, 5'. Die IGBT-Module 3, 3', 4, 4', 5, 5' sind über das Gleichstromlaminat 6 mit den Kondensatoren 2 der Kondensatorbank 8 unter Verwendung von Adapterlaminaten 7 elektrisch leitend verbunden.

Wie in Figur 1 zu erkennen ist, ist zwischen den achsensymmetrisch angeordneten IGBT-Modulen 3, 4, 5 und 3', 4', 5' ein Kühlkörper 9 angeordnet, welcher eine Einlassöffnung 10 und eine Auslassöffnung 11 für ein Kühlmedium aufweist. Die Auslassöffnung für das Kühlmedium kann an der der Einlassöffnung 10 gegenüberliegenden Seite des Kühlkörpers (nicht dargestellt) aber auch, wie dargestellt, auf der gleichen Seite angeordnet sein. Wie aus Figur 1 ersichtlich, ergibt sich durch die achsensymmetrische Anordnung der elektronischen Leistungsschalter mit dem dazwischen liegenden Kühlkörper ein besonders kompakter Aufbau der Schaltungsanordnung 1. Darüber hinaus ist zu erkennen, dass zur Anpassung der Schaltungsanordnung an unterschiedliche Funktionalitäten oder Leistungen, beispielsweise Kondensatoren oder elektronische Leistungsschalter entfernt oder durch andere elektronische Leistungsschalter ersetzt werden können. So ist es beispielsweise ohne Weiteres möglich, die IGBT-Module 3', 4', 5' durch Dioden zu ersetzen, um anstelle eines 4-Quadranten einen 2-Quadranten Umrichter zu realisieren. Eine konstruktive Änderung der Schaltungsanordnung ist hierzu nicht erforderlich. Denkbar ist auch ein zweiphasiger Aufbau der elektronischen Leistungsschalter beispielsweise im Bereich der Haustechnik zur Erzeugung einphasigen Wechselstroms.

Die Wechselstromanschlüsse der IGBT-Module 3, 4, 5, 3', 4', 5' sind im dargestellten Ausführungsbeispiel über Kupferschienen 27, 28 realisiert, welche eine einseitige Wechselstromzufuhr ermöglichen. Denkbar sind aber auch andere geometrische Anordnung der Kupferschienen, beispielsweise beidseitig der IGBT-Module 3, 4, 5, 3', 4', 5' oder zentral entlang der Symmetrieachse der IGBT-Module 3, 4, 5, 3', 4', 5' aber auch eine Realisierung der Wechselstromanschlüsse durch Kabel (jeweils nicht dargestellte).

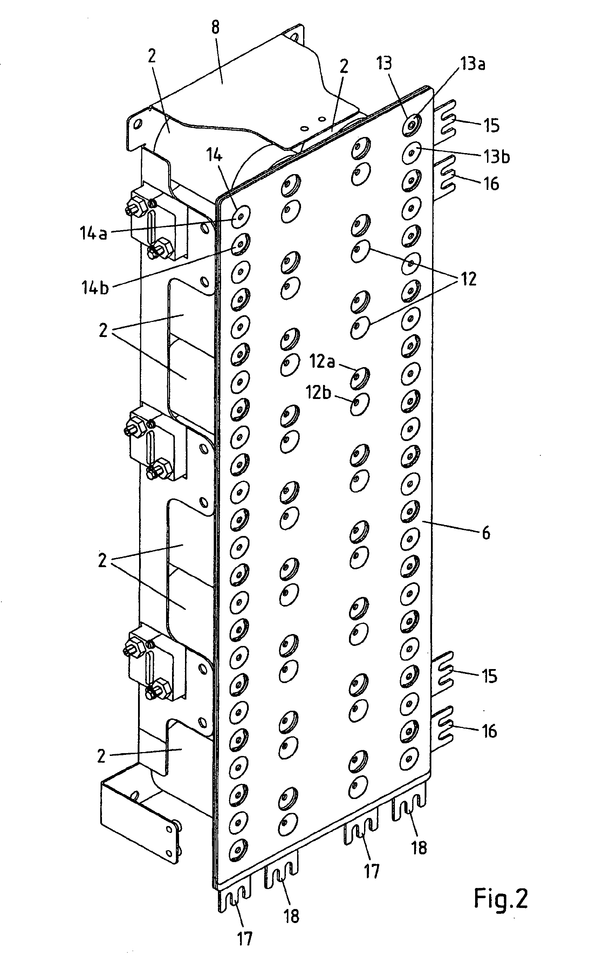

Figur 2 zeigt nun das Gleichstromlaminat 6 sowie die zugehörigen Kondensatoren 2 in einer perspektivischen Ansicht. Das Gleichstromlaminat 6 weist in einem ersten Rastermaß angeordnete Anschlusselemente 12 auf, welche zum Anschluss der einzelnen Kondensatoren 2 der Kondensatorbank 8 dienen. Das erste Rastermaß ist deshalb an die Größe und Anschlussabstände der Kondensatoren angepasst.

Darüber hinaus weist das Gleichstromlaminat eine Mehrzahl an Anschlusselementen 13 auf, welche in einem zweiten Rastermaß angeordnet sind und dazu dienen, die elektronischen Leistungsschalter, vorliegend die IGBT-Module 3, 4, 5, 3', 4', 5' mit dem Gleichstromlaminat 6 elektrisch zu verbinden. In Figur 2 sind die unterschiedlichen elektrischen Pole, also der Pluspol und der Minuspol der Anschlusselemente 12, 13 jeweils durch unterschiedlich vertieft dargestellte Anschlusselemente 12a, 12b, 13a, 13b des Gleichstromlaminats 6 dargestellt. Die Anschlusselemente 13 sind von ihrer Polung her so angeordnet, dass eine achsensymmetrische Anordnung von einer Mehrzahl an Leistungsmodulen, wie sie im ersten Ausführungsbeispiel dargestellt ist, mit dem Gleichstromlaminat 6 elektrisch verbindbar ist. Hierdurch wird ein besonders kompakter Aufbau der Schaltungsanordnung 1 erzielt.

Im vorliegenden Ausführungsbeispiel wird dies dadurch erreicht, dass gegenüberliegende im zweiten Rastermaß angeordnete Anschlusselemente 13, 14 unterschiedliche elektrische Polungenaufweisen. Dies ermöglicht unter Verwendung von Adapterlaminaten eine Anordnung der IGBT-Module 3, 4, 5, 3', 4', 5' auf der einen Seite des Gleichstromlaminats 6 in der Form, dass die Kühlflächen der IGBT-Module senkrecht zum Gleichstromlaminat und gegenüberliegend angeordnet sind.

Darüber hinaus zeigt das in Figur 2 dargestellte Gleichstromlaminat 6 beispielhaft weitere Anschlussmittel 15, 16, 17 sowie 18 zum Anschließen weiterer Gleichstromlaminate 6 entweder in horizontaler Richtung oder in vertikaler Richtung. Die Schaltungsanordnung 1 kann dadurch noch flexibler skaliert werden.

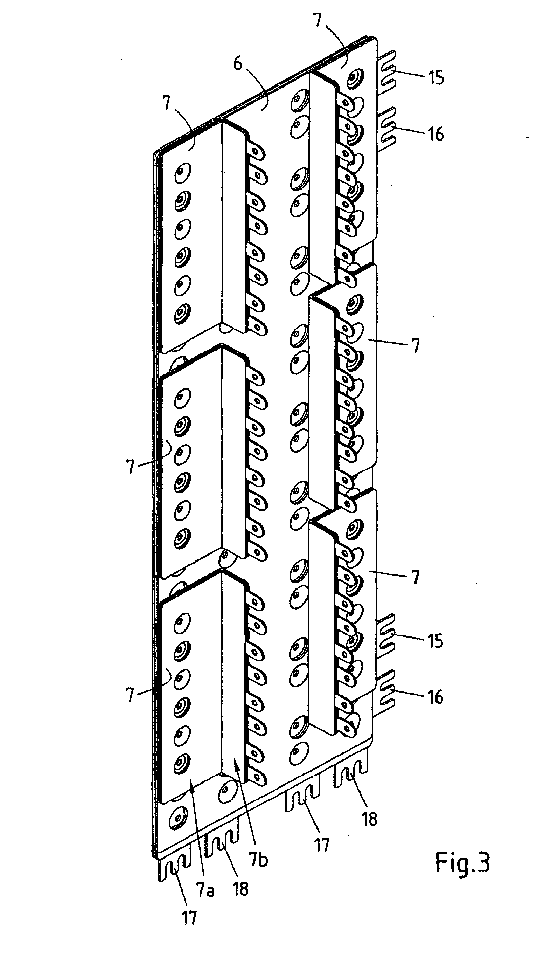

In Figur 3 ist nun das Gleichstromlaminat 6 mit insgesamt sechs Adapterlaminaten 7 in einer perspektivischen Ansicht dargestellt. Erfindungsgemäß besitzt das Adapterlaminat 7 zwei Anschlussbereiche, nämlich die dem Gleichstromlaminat 6 zugewandte Seite 7a sowie die den elektronischen Leistungsschaltern zugewandte Anschlussseite 7b. Die Anschlussseite 7a des Adapterlaminats 7 ist an das zweite Rastermaß der Anschlusselemente des Gleichstromlaminats 6 angepasst und weist am anderen Ende, der Anschlussseite zu den elektronischen Leistungsschaltern 7b zusätzliche Anschlusselemente auf, welche spezifisch an die elektronischen Leistungsschalter angepasst sind. Elektronische Leistungsschalter unterschiedlicher Hersteller mit einer anderen Anschlusskonfiguration können verwendet werden, indem nur das Adapterlaminat 7 an die Anschlussgeometrie angepasst wird. Das Gleichstromlaminat 6 bleibt unverändert. Es ist auch selbstverständlich, dass die im zweiten Rastermaß angeordneten Anschlussstellen 13, 14 des Gleichstromlaminats 6 bereits derart angeordnet sind, dass die elektronischen Leistungsschalter auch unmittelbar mit dem Gleichstromlaminat verbunden werden können.

Die Adapterlaminate 7 stellen sicher, dass die Anschlusselemente 13, 14 auch mit elektronischen Leistungsschaltern unterschiedlicher Hersteller genutzt werden können. Wie in Figur 3 zu sehen ist, weisen die Adapterlaminate einen rechten Winkel auf, so dass diese auf einfache Weise ermöglichen, dass die elektronischen Leistungsschalter 3, 4, 5, 3', 4', 5' mit gegenüberliegenden Kühlflächen angeordnet werden können, so dass ein einziger Kühlkörper 9 ausreicht, um eine Mehrzahl an elektronischen Leistungsschaltern zu kühlen. Darüber hinaus ist aus Figur 3 ersichtlich, dass die Adapterlaminate 7 in ihrer dargestellten Form eine besonders geringe Induktanz aufweisen und damit ideal zur Führung hoher Stromspitzen geeignet sind.

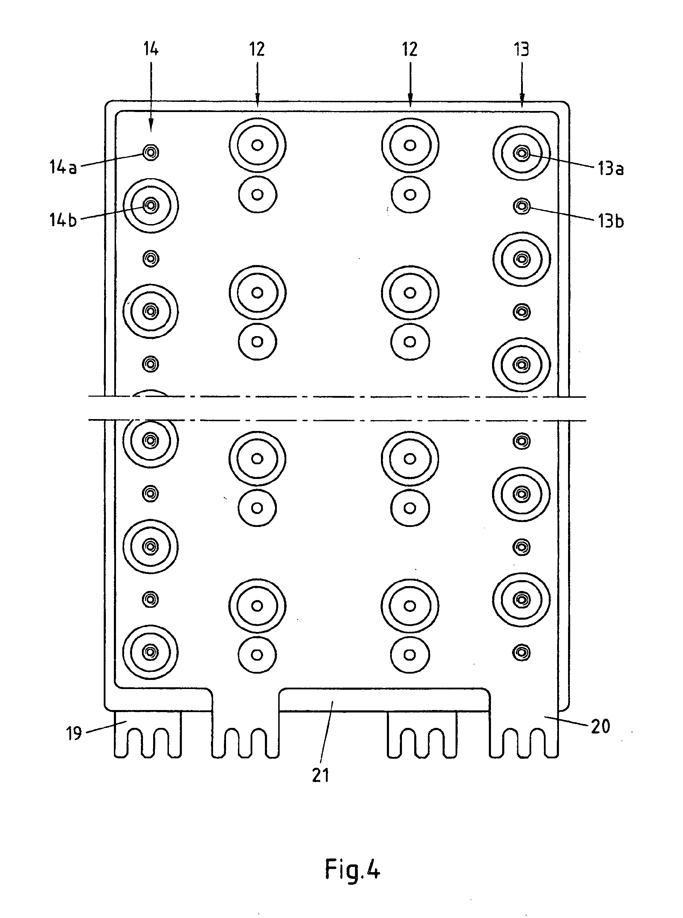

Figur 4 zeigt noch einmal den Aufbau des Gleichstromlaminats, welches aus im Wesentlichen zwei stromführenden Metallplatten 19, 20 besteht, zwischen welchen eine Isolierschicht 21 angeordnet ist. Darüber hinaus ist das Gleichstromlaminat optional von beiden Seiten mit einer Isolierschicht versehen, welche in Figur 4 nicht dargestellt ist. Zusätzlich ist das unterschiedliche Rastermaß der Anschlusselemente 12 im Vergleich zu den Anschlusselementen 13 und 14 zu erkennen. Unterschiedliche Anschlusspole des Gleichstromlaminats sind mit unterschiedlich großen Anschlusselementen dargestellt.

Es ist weiter erkennbar, dass die in der gleichen Ebene angeordneten Anschlusselemente 13a und 14a, respektive 13b und 14b der im zweiten Rastermaß angeordneten Anschlusselemente 13, 14 jeweils unterschiedliche Polung aufweisen und damit den Anschluss von achsensymmetrisch angeordneten elektronischen Leistungsschaltern ermöglichen. Die elektronischen Leistungsschalter werden hierzu in jeweils 180 Grad gedrehter Position angeordnet, wie in Figur 1 dargestellt ist. Es ist aber auch denkbar, die Polung der Anschlusselemente identisch zu gestalten und die Adapterlaminate 7 so anzupassen, dass diese die achsensymmetrische Anordnung der elektronischen Leistungsschalter ermöglichen. Dies würde aber zwei verschiedene Adapterlaminate 7 erfordern.

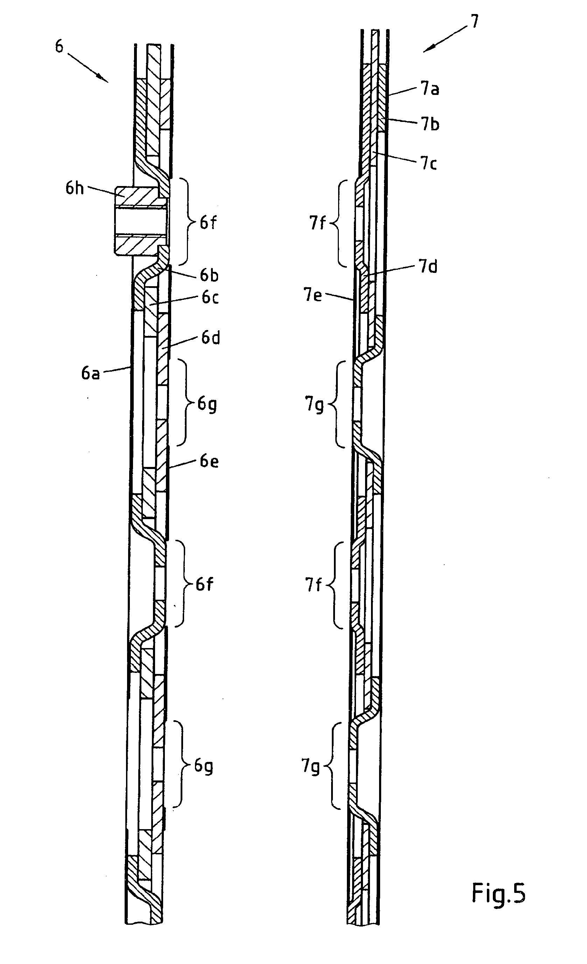

In Figur 5 ist nun das Gleichstromlaminat 6 als auch das Adapterlaminat 7 in einer Schnittansicht dargestellt. Das Gleichstromlaminat besteht aus den stromführenden Metallplatten 6b und 6d mit einer dazwischen angeordneten Isolierschicht 6c sowie optional zwei äußeren Isolierschichten 6a und 6e. Einen ähnlichen Aufbau hat auch das Adapterlaminat 7, dessen stromführende Metallplatten mit 7b und 7d, die dazwischenliegende Isolierschicht mit 7c und die optionalen außenliegenden Isolierschichten mit 7a und 7e bezeichnet sind. Die Kontaktierung des entsprechenden Anschlusspols des Gleichstromlaminats 6 bzw. des Adapterlaminats 7 erfolgt über die Kontaktflächen 6f, 6g und 7f, 7g. Bei Verwendung außenliegender Isolierschichten 6a, 6e, 7a und 7e sind an den Kontaktstellen Auslassungen in der Isolierschicht vorzusehen.

Wie in Figur 5 weiter zu erkennen ist, werden die Metallplatten derart geformt, dass die Kontaktflächen 6f und 6g des Gleichstromlaminats 6 sowie 7f und 7g des Adapterlaminats 7 jeweils in einer Ebene liegen. Dadurch wird es möglich, das Gleichstromlaminat direkt mit dem Adapterlaminat zu verbinden, ohne zusätzliche Elemente wie Metallhülsen zum Ausgleich unterschiedlicher Höhen einsetzen zu müssen.

Zum elektrischen sowie kraft- und formschlüssigen Verbinden der beiden Laminate können beispielsweise Schrauben mit Muttern eingesetzt werden. Als vorteilhaft erweisen sich auch Einpresshülsen mit Innengewinde 6h, welche optional anstelle einer Mutter verwendet werden können. Diese Hülsen 6h werden beispielsweise in das Gleichstromlaminat 6 eingepresst. Dies bietet Vorteile bei der Montage, da so das Adapterlaminat mit dem Gleichstromlaminat einhändig verschraubt werden kann und damit eine schnelle und einfache Montage bzw. Austausch zu Servicezwecken ermöglicht wird. Wie bereits ausgeführt, können die Hülsen 6h stoff-, kraft- oder formschlüssig mit dem Gleichstromlaminat 6 verbunden sein. Das Einpressen der Hülsen 6h ist eine Kombination aus kraft- und formschlüssiger Verbindung.

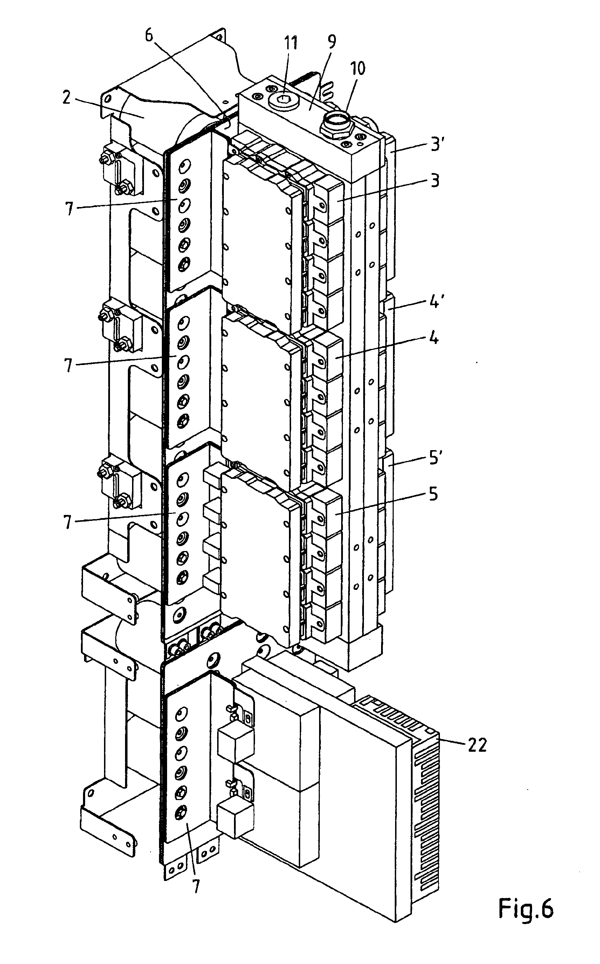

Figur 6 zeigt nun in einer perspektivischen Darstellung die erfindungsgemäße Schaltungsanordnung aus Figur 1, welche um ein zusätzliches Modul, dem Chopper-Modul 22 erweitert worden ist. Das Chopper-Modul 22 dient dazu, die Kondensatoren 2 sowie die IGBT-Module 3, 4, 5, 3', 4', 5' vor Überspannungen zu schützen. Die Kombination der IGBT-Module 3, 4, 5, 3', 4', 5' mit einem zusätzlich auf dem Gleichstromlaminat 6 angeordneten Chopper-Modul 22 erlaubt die direkte Anbindung des Chopper-Moduls an die Kondensatorbank. Es wird somit auf eine Kabelverbindung zwischen dem Gleichstromlaminat 6 und dem Chopper-Modul 22 verzichtet. Da die Zwischenkreisspannung regelmäßig über 1000V liegt, ist dies sowohl aus sicherheitstechnischen Aspekten als auch im Hinblick auf die elektromagnetische Verträglichkeit der Schaltungsanordnung vorteilhaft. Des Weiteren ergibt sich eine Reduzierung des Platzbedarfs.

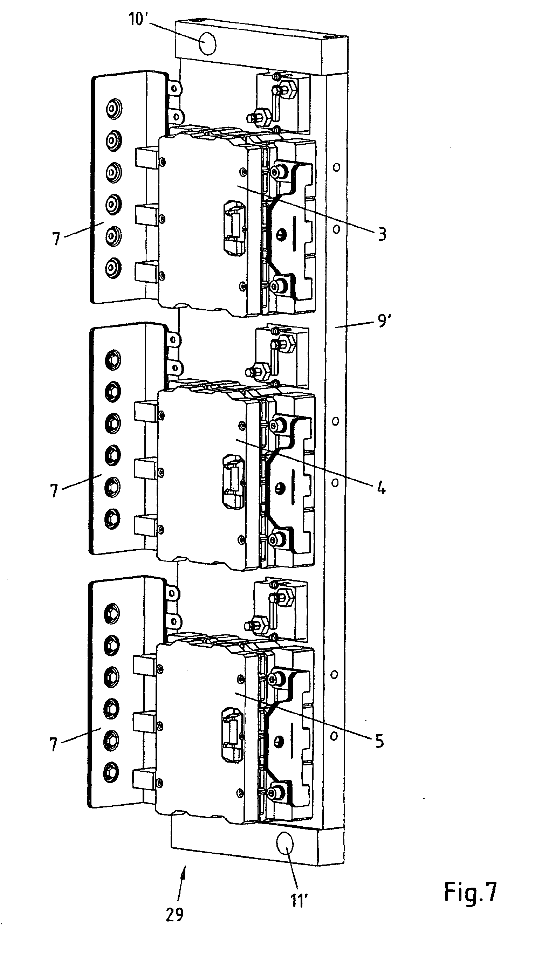

Eine Baueinheit 29 bestehend aus Leistungsschaltern 3, 4, 5 mit zugehörigem separaten Kühlkörper 9' und Adapterlaminaten 7 zeigt Fig. 7 in einer perspektivischen Darstellung. Die Kühlmittelanschlüsse 10' und 11' sind seitlich ausgeführt, so dass unabhängig von der Tiefe des Kühlkörpers ausreichend große Anschlussgeometrien zur Verfügung gestellt werden können. Der Kühlkörper 9' stellt zwar einen separaten Kühlkörper dar. Dennoch ist dieser modular im Sinne der vorliegenden Erfindung aufgebaut, denn er lässt sich mit anderen spiegelsymmetrisch angeordneten Kühlkörpern kombinieren und damit auch einem oder mehreren anderen Leistungsschaltern 3,4,5 zuordnen.

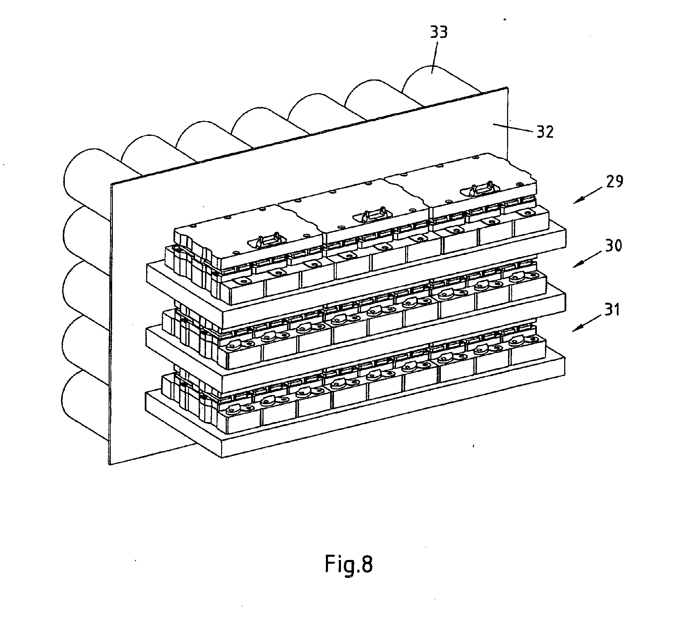

Die Baueinheit 29 bestehend aus Leistungsschaltern 3, 4, 5, dem Kühlkörper 9' und den Adapterlaminaten 7 kann auf einem "großen" Gleichstromlaminat 32 gemeinsam mit anderen Baueinheiten 30, 31 parallel in horizontaler oder vertikaler Richtung angeordnet werden. Dies zeigt Fig. 8 in einem weiteren Ausführungsbeispiel. Das Gleichstromlaminat 32 kann aus einem einzigen durchgehenden Gleichstromlaminat oder aus miteinander elektrisch verbundenen Gleichstromlaminaten bestehen (nicht dargestellt). Die Verbindung der Gleichstromlaminate wird gegebenenfalls auch durch Adapterlaminate bereitgestellt. Auf der Rückseite des Gleichstromlaminats 32 sind die Kondensatoren 33 angeordnet. Bei der in Fig. 8 dargestellten Schaltungsanordnung kann eine einzelne Baueinheit 29, 30, 31 auf einfache Weise ersetzt werden, sofern diese beispielsweise defekt ist. Darüber hinaus ist eine Skalierbarkeit sehr einfach durch Hinzufügen oder Entfernen der Baueinheiten 29, 30 ,31 möglich.

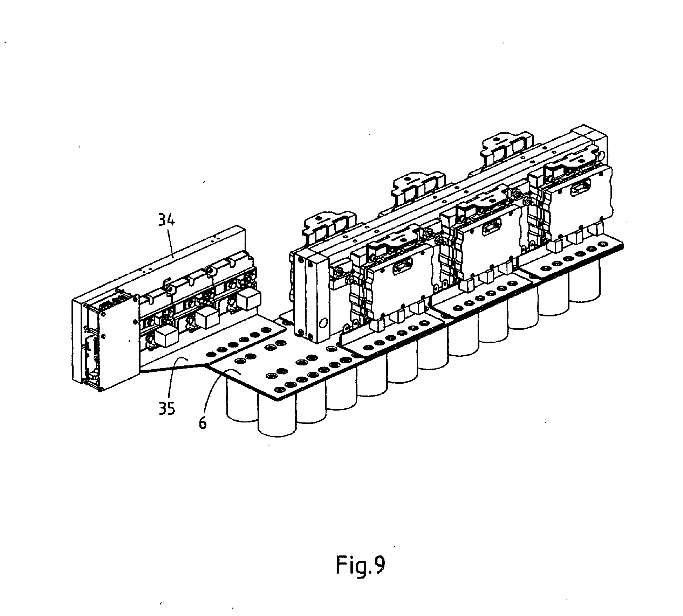

Fig. 9 zeigt in einer perspektivischen Darstellung ein weiteres Ausführungsbeispiel mit einem Chopper-Modul 34, welches über ein zusätzliches Adapterlaminat 35 an das Gleichstromlaminat 6 angebunden ist. Hierdurch besteht die Möglichkeit, das Chopper-Modul 34 flexibeler in der Schaltungsanordnung anzuordnen.

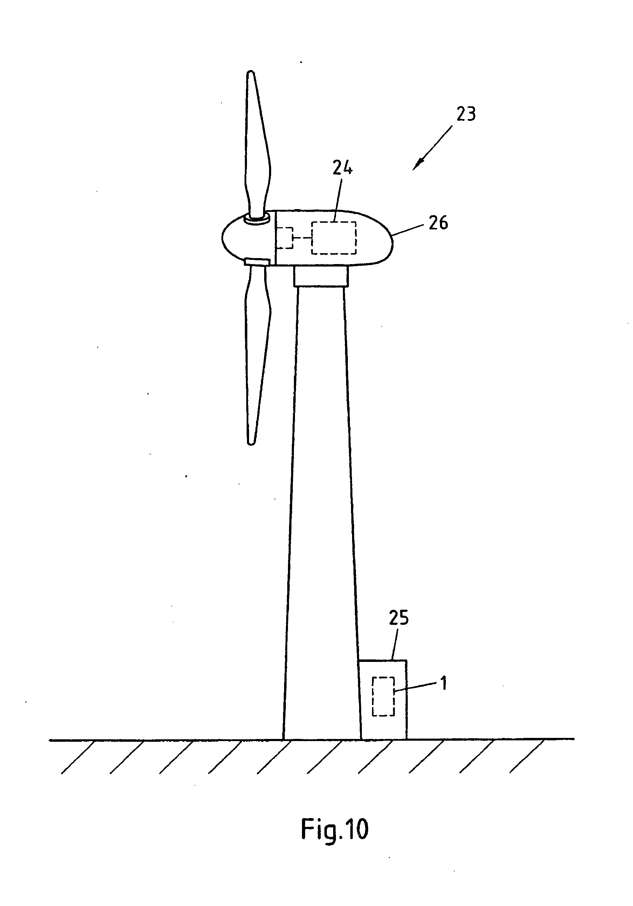

Figur 10 zeigt nun schematisch eine Windenergieanlage 23 mit einem Generator 24 und einer erfindungsgemäßen Schaltungsanordnung 1. Die Schaltungsanordnung 1 ist in einem Schaltkasten 25 am Fuß der Windenergieanlage montiert. Häufig wird die Schaltungsanordnung 1 aber auch in der Nähe des Generators 24, also beispielsweise in der Gondel 26 der Windenergieanlage 23 angeordnet. Aufgrund des geringen Platzangebotes in Windenergieanlagen, insbesondere in der Kanzel der Windenergieanlage 23 sowie der notwendigen Anpassung der Windenergieanlagen 23 an unterschiedliche Leistungsbereiche ist die Verwendung der erfindungsgemäßen Schaltungsanordnung 1 für Windenergieanlagen 23 besonders vorteilhaft.

## Patentansprüche

1. Schaltungsanordnung (1) mit mindestens einem elektronischen Leistungsschalter (3, 4, 5, 3', 4', 5'), mindestens einem Kondensator (2) und einem plattenförmigen Gleichstromlaminat (6), wobei das Gleichstromlaminat (6) mindestens zwei gegeneinander isolierte Metallplatten (6b, 6d) zur Stromführung und eine Mehrzahl in einem ersten Rastermaß angeordnete Anschlusselemente (12) zum elektrischen Verbinden der Metallplatten (6b, 6d) mit dem mindestens einen Kondensator (2) aufweist, der mindestens eine Kondensator (2) über die im ersten Rastermaß angeordneten Anschlusselemente (12) mit dem Gleichstromlaminat (6) elektrisch leitend verbunden ist, der mindestens eine Kondensator (2) auf einer Seite des Gleichstromlaminats (6) angeordnet ist, das Gleichstromlaminat (6) zusätzlich eine Mehrzahl in einem zweiten Rastermaß angeordneter Anschlusselemente (13, 14) zum Verbinden des Gleichstromlaminats (6) mit mindestens einem elektronischen Leistungsschalter (3, 4, 5, 3', 4', 5') der Schaltungsanordnung aufweist, der mindestens ein elektronischer Leistungsschalter (3, 4, 5, 3', 4', 5') über die im zweiten Rastermaß angeordneten Anschlusselemente (13, 14) mit dem Gleichstromlaminat elektrisch verbunden ist und auf der gegenüberliegenden Seite des Gleichstromlaminats (6) angeordnet ist, wobei elektronische Leistungsschalter (3, 4, 5, 3', 4', 5') für drei Phasen vorgesehen sind und die auf der einen Seite des Gleichstromlaminats angeordneten elektronischen Leistungsschalter (3, 4, 5, 3', 4', 5') zumindest teilweise einen gemeinsamen Kühlkörper (9) aufweisen,
**dadurch gekennzeichnet, dass** mindestens ein Adapterlaminat (7) zum Anschluss der elektronischen Leistungsschalter (3, 4, 5, 3', 4', 5') vorgesehen ist, wobei das Adapterlaminat (7) auf einer Anschlussseite (7b) an die elektronischen Leistungsschalter angepasste Anschlusselemente und auf der anderen Anschlussseite (7a) an das zweite Rastermaß angepasste Anschlusselemente aufweist.

2. Schaltungsanordnung nach Anspruch 1,
**dadurch gekennzeichnet, dass** eine Mehrzahl parallel geschalteter Kondensatoren (2), vorzugsweise eine Kondensatorbank (8) vorgesehen ist und die einzelnen Kondensatoren über die im ersten Rastermaß angeordneten Anschlusselemente (12) mit dem Gleichstromlaminat (6) elektrisch leitend verbunden sind.

3. Schaltungsanordnung nach Anspruch 1 oder 2,
**dadurch gekennzeichnet, dass** die im zweiten Rastermaß angeordneten Anschlusselemente (13, 14) des Gleichstromlaminats (6) derart ausgebildet sind, dass eine Mehrzahl an elektronischen Leistungsschaltern (3, 4, 5, 3', 4', 5') in achsensymmetrischer Anordnung mit dem Gleichstromlaminat (6) elektrisch leitend verbunden werden können.

4. Schaltungsanordnung nach einem der Ansprüche 1 bis 3,
**dadurch gekennzeichnet, dass** die im zweiten Rastermaß angeordneten Anschlusselemente (13, 14) des Gleichstromlaminats (6) Hülsen (6h) mit einem Innengewinde aufweisen.

5. Schaltungsanordnung nach einem der Ansprüche 1 bis 4,
**dadurch gekennzeichnet, dass** die Querschnittsform des Adapterlaminats (7) mindestens einen rechten Winkel aufweist.

6. Schaltungsanordnung nach einem der Ansprüche 1 bis 5,
**dadurch gekennzeichnet, dass** die Kontaktflächen (6f, 6g) der im zweiten Rastermaß angeordneten Anschlusselemente des Gleichstromlaminats (6) und/oder die Kontaktflächen (7f, 7g) der an das zweite Rastermaß angepassten Anschlusselemente des Adapterlaminats (7) in einer Ebene angeordnet sind.

7. Schaltungsanordnung nach einem der Ansprüche 1 bis 6,
**dadurch gekennzeichnet, dass** mindestens ein durch ein flüssiges Kühlmedium und/oder durch Luft gekühlter Kühlkörper (9) vorgesehen ist, welcher optional modular aufgebaut ist.

8. Schaltungsanordnung nach einem der Ansprüche 1 bis 7,
**dadurch gekennzeichnet, dass** der einem Leistungsschalter oder einer Gruppe von Leistungsschaltern zugeordneter Kühlkörper (9') jeweils separate Kühlmittelanschlüsse (10',11') aufweist.

9. Schaltungsanordnung nach einem der Ansprüche 1 bis 8,
**dadurch gekennzeichnet, dass** eine Mehrzahl an Gleichstromlaminaten (6) vorgesehen sind, welche über im Gleichstromlaminat (6) jeweils vorgesehene Anschlussmittel (15, 16, 17, 18) miteinander elektrisch leitend verbunden sind.

10. Schaltungsanordnung nach einem der Ansprüche 1 bis 9,
**dadurch gekennzeichnet, dass** das erste und/oder das zweite Rastermaß des Gleichstromlaminats unterschiedliche Kondensator- oder Leistungsschalteranschlussgeometrien berücksichtigt.

11. Schaltungsanordnung nach einem der Ansprüche 1 bis 10,
**dadurch gekennzeichnet, dass** als elektronische Leistungsschalter (3, 4, 5, 3', 4', 5') mindestens ein Transistor, vorzugsweise mindestens ein Insulated-Gate-Bipolar-Transistor-(IGBT)-Modul, Integrated-Gate-Commutated-Thyristor(IGCT), Dioden und/oder mindestens ein Chopper-Modul (22) vorgesehen ist.

12. Stromerzeugungsvorrichtung mit einem Wechsel- oder Gleichrichter umfassend eine Schaltungsanordnung nach einem der Ansprüche 1 bis 11.

13. Stromerzeugungsvorrichtung nach Anspruch 12,
**dadurch gekennzeichnet, dass** die Stromerzeugungsvorrichtung eine Windenergieanlage mit einem Generator ist, welche einen Gleich- oder Wechselrichter aufweist und die Gleich- oder Wechselrichter die Schaltungsanordnung aufweisen.

## Claims

1. Circuit arrangement (1) with at least one electronic power switch (3, 4, 5, 3', 4', 5'), at least one capacitor (2) and a plate-shaped direct current laminate (6), the direct current laminate (6) having at least two metal plates (6b, 6d) insulated from one another for carrying current and a plurality of connection elements (12) arranged at a first spacing to electrically connect the metal plates (6b, 6d) to the at least one capacitor (2), the at least one capacitor (2) being electrically conductively connected by the connection elements (12) arranged at the first spacing to the direct current laminate (6) and the at least one capacitor (2) being arranged on one side of the direct current laminate (6), the direct current laminate (6) additionally has a plurality of connection elements (13, 14) arranged at a second spacing to connect the direct current laminate (6) to at least one electronic power switch (3, 4, 5, 3', 4', 5') of the circuit arrangement, the at least one electronic power switch (3, 4, 5, 3', 4', 5') is electrically connected by the connection elements (13, 14) arranged at the second spacing to the direct current laminate and is arranged on the opposing side of the direct current laminate (6), wherein electronic power switches (3, 4, 5, 3', 4', 5') for three phases are provided and the electronic power switches (3, 4, 5, 3', 4', 5') arranged on one side of the direct current laminate at least partially have a common cooling body (9),
**characterized in that**
at least one adapter laminate (7) is provided to connect the electronic power switches (3, 4, 5, 3', 4', 5'), the adapter laminate (7) having connection elements adapted to the electronic power switches on one connection side (7b) and having connection elements adapted to the second spacing on the other connection side (7a).

2. Circuit arrangement according to claim 1, **characterised in that** a plurality of capacitors (2) connected in parallel, preferably a capacitor bank (8), is provided and the individual capacitors are electrically conductively connected by the connection elements (12) arranged at a first spacing to the direct current laminate (6).

3. Circuit arrangement according to claim 1 or 2, **characterised in that** the connection elements (13, 14), which are arranged at the second spacing, of the direct current laminate (6) are configured in such a way that a plurality of electronic power switches (3, 4, 5, 3', 4', 5') can be electrically conductively connected in an axially symmetrical arrangement to the direct current laminate (6).

4. Circuit arrangement according to any one of claims 1 to 3, **characterised in that** the connection elements (13, 14), which are arranged at the second spacing, of the direct current laminate (6) have sleeves (6h) with an internal thread.

5. Circuit arrangement according to any one of claims 1 to 4, **characterised in that** the cross-sectional shape of the adapter laminate (7) has at least one right angle.

6. Circuit arrangement according to any one of claims 1 to 5, **characterised in that** the contact faces (6f, 6g) of the connection elements, which are arranged at the second spacing, of the direct current laminate (6) and/or the contact faces (7f, 7g) of the connection elements, which are adapted to the second spacing, of the adapter laminate (7) are arranged in one plane.

7. Circuit arrangement according to any one of claims 1 to 6, **characterised in that** at least one cooling body (9) cooled by a liquid cooling medium and/or by air is provided and is optionally modularly constructed.

8. Circuit arrangement according to any one of claims 1 to 7, **characterised in that** the cooling body (9') associated with a power switch or a group of power switches in each case has separate coolant connections (10', 11').

9. Circuit arrangement according to any one of claims 1 to 8, **characterised in that** a plurality of direct current laminates (6) are provided, which are electrically conductively connected to one another by respective connection means (15, 16, 17, 18) provided in the direct current laminate (6).

10. Circuit arrangement according to any one of claims 1 to 9, **characterised in that** the first and/or the second spacing of the direct current laminate takes into account different capacitor or power switch connection geometries.

11. Circuit arrangement according to any one of claims 1 to 10, **characterised in that** at least one transistor, preferably at least one insulated gate bipolar transistor (IGBT) module, integrated gate commutated thyristor (IGCT), diodes and/or at least one chopper module (22) is provided as the electronic power switch (3, 4, 5, 3', 4', 5').

12. Power generation device with an inverter or rectifier comprising a circuit arrangement according to any one of claims 1 to 11.

13. Power generation device according to claim 12, **characterised in that** the power generation device is a wind energy plant with a generator, which has a rectifier or an inverter and the rectifiers or inverters have the circuit arrangement.

## Revendications

1. Agencement de circuit (1) avec au moins un disjoncteur de puissance électronique (3, 4, 5, 3', 4', 5'), au moins un condensateur (2) et un laminé à courant continu (6) en forme de plaque, le laminé à courant continu (6) présentant au moins deux plaques métalliques (6b, 6d) isolées l'une par rapport à l'autre pour conduire du courant et une pluralité d'éléments de connexion (12) disposés selon un premier pas de fixation pour la connexion électrique des plaques métalliques (6b, 6d) à l'au moins un condensateur (2), l'au moins un condensateur (2) étant connecté, via les éléments de connexion (12) disposés selon le premier pas de fixation, au laminé à courant continu (6) de manière électro-conductrice, l'au moins un condensateur (2) étant disposé sur un côté du laminé à courant continu (6), le laminé à courant continu (6) présentant additionnellement une pluralité d'éléments de connexion (13, 14) disposés selon un deuxième pas de fixation pour connecter le laminé à courant continu (6) à au moins un disjoncteur de puissance électronique (3, 4, 5, 3', 4', 5') de l'agencement de circuit, l'au moins un disjoncteur de puissance électronique (3, 4, 5, 3', 4', 5') étant connecté électriquement, via les éléments de connexion (13, 14) disposés selon le deuxième pas de fixation, au laminé à courant continu et étant disposé sur le côté opposé du laminé à courant continu (6), des disjoncteurs de puissance électroniques (3, 4, 5, 3', 4', 5') pour trois phases étant prévus et les disjoncteur de puissance électroniques (3, 4, 5, 3', 4', 5') disposés sur l'un des côtés du laminé à courant continu présentant au moins partiellement un corps de refroidissement (9) commun,
**caractérisé en ce que** l'on prévoit au moins un laminé d'adaptateur (7) pour le raccordement des disjoncteurs électroniques (3, 4, 5, 3', 4', 5'), le laminé d'adaptateur (7) présentant, sur un côté de connexion (7b), des éléments de connexion adaptés aux disjoncteurs électroniques et sur l'autre côté de connexion (7a), des éléments de connexion adaptés au deuxième pas de fixation.

2. Agencement de circuit selon la revendication 1, **caractérisé en ce qu'**une pluralité de condensateurs (2) montés en parallèle est prévue, de préférence un banc de condensateurs (8), et **en ce que** les condensateurs individuels sont connectés de manière électro-conductrice, via les éléments de connexion (12) disposés selon le premier pas de fixation, au laminé à courant continu (6).

3. Agencement de circuit selon la revendication 1 ou 2, **caractérisé en ce que** les éléments de connexion (13, 14) du laminé à courant continu (6) disposés selon le deuxième pas de fixation sont réalisés de manière à ce qu'il soit possible de connecter de manière électro-conductrice une pluralité de disjoncteurs de puissance électroniques (3, 4, 5, 3', 4', 5') selon une disposition symétrique par rapport à un axe au laminé à courant continu (6).

4. Agencement de circuit selon l'une des revendications 1 à 3, **caractérisé en ce que** les éléments de connexion (13, 14) du laminé à courant continu (6) disposés selon le deuxième pas de fixation présentent des cosses (6h) avec un filetage intérieur.

5. Agencement de circuit selon l'une des revendications 1 à 4, **caractérisé en ce que** la forme en coupe transversale du laminé d'adaptateur (7) présente au moins un angle droit.

6. Agencement de circuit selon l'une des revendications 1 à 5, **caractérisé en ce que** les surfaces de contact (6f, 6g) des éléments de connexion du laminé à courant continu (6) disposés selon le deuxième pas de fixation et/ou les surfaces de contact (7f, 7g) des éléments de connexion du laminé d'adaptateur (7) adaptés au deuxième pas de fixation sont disposées dans un plan.

7. Agencement de circuit selon l'une des revendications 1 à 6, **caractérisé en ce qu'**au moins un corps de refroidissement (9) refroidit par un agent réfrigérant liquide et/ou par de l'air est prévu, lequel est monté en option de manière modulaire.

8. Agencement de circuit selon l'une des revendications 1 à 7, **caractérisé en ce que** le corps de refroidissement (9') associé à un disjoncteur de puissance ou à un groupe de disjoncteurs de puissance présente respectivement des branchements d'agent de refroidissement (10', 11') séparés.

9. Agencement de circuit selon l'une des revendications 1 à 8, **caractérisé en ce qu'**une pluralité de laminés à courant continu (6) sont prévus, lesquels sont connectés ensemble de manière électro-conductrice via des moyens de connexion (15, 16, 17, 18) respectivement prévus dans le laminé à courant continu (6).

10. Agencement de circuit selon l'une des revendications 1 à 9, **caractérisé en ce que** le premier et/ou le deuxième pas de fixation du laminé à courant continu tient compte de différentes géométries de connexion de condensateur ou de disjoncteur de puissance.

11. Agencement de circuit selon l'une des revendications 1 à 10, **caractérisé en ce que** l'on prévoit, en guise de disjoncteurs de puissance électroniques (3, 4, 5, 3', 4', 5'), au moins un transistor, de préférence au moins un module à Insulated-Gate-Bipolar-Transistor (IGBT), un Integrated-Gate-Commutated-Thyristor (IGCT), des diodes et/ou au moins un module de hachage (22).

12. Dispositif de production de courant avec un onduleur ou un redresseur comprenant un agencement de circuit selon l'une des revendications 1 à 11.

13. Dispositif de production de courant selon la revendication 12, **caractérisé en ce que** le dispositif de production de courant est une installation éolienne avec un générateur, laquelle présente un onduleur ou redresseur et les onduleurs ou redresseurs présentant l'agencement de circuit.
